# EUROPÄISCHE PATENTANMELDUNG

(11) **EP 3 937 261 A1**
(43) Veröffentlichungstag der Anmeldung: **12.01.2022**
(21) Anmeldenummer: 21000174.9
(22) Anmeldetag: 01.07.2021
(51) Int. Cl.: H01L 31/0687, H01L 31/068, H01L 31/0304

(54) **STAPELFÖRMIGE MONOLITHISCHE MEHRFACHSOLARZELLE**

(30) Priorität: 10.07.2020 DE 102020004170
(71) Anmelder: AZUR SPACE Solar Power GmbH, 74072 Heilbronn (DE)
(72) Erfinder: Fuhrmann, Daniel, 74081 Heilbronn (DE); van Leest, Rosalinda, 4921 LE Made (NL); Keller, Gregor, 74080 Heilbronn (DE); Meusel, Matthias, 74076 Heilbronn (DE)
(74) Vertreter: Koch Müller Patentanwaltsgesellschaft mbH

(57) **Zusammenfassung**

Die Erfindung betrifft eine stapelförmige monolithische Mehrfachsolarzelle aufweisend eine erste Teilzelle mit einem p/n Übergang mit einer Emitterschicht und einer Basisschicht, wobei die Dicke der Emitterschicht wenigstens um einen Faktor zehn kleiner ist als die Dicke der Basisschicht und die erste Teilzelle ein Substrat mit einem Halbleitermaterial aus der Gruppe III und V oder ein Substrat aus der Gruppe IV umfasst und weiterhin aufweisend eine auf der ersten Teilzelle angeordnete zweite Teilzelle und eine auf der zweiten Teilzelle angeordnete dritte Teilzelle, wobei die beiden Teilzellen jeweils eine Emitterschicht und eine Basisschicht aufweisen und zwischen den Teilzellen jeweils eine Tunneldiode und eine Rückseitenfeldschicht ausgebildet ist, wobei bei der zweiten Teilzelle und bei der dritten Teilzelle jeweils die Dicke der Emitterschicht größer ist als die Dicke der Basisschicht.

## Beschreibung

Aus der EP 2 264 788 A1 ist eine stapelförmige monolithische Mehrfachsolarzelle bekannt. Weitere Mehrfachsolarzellen sind der US 2014 / 0 076 391 A1, der US 2014 / 0 261 611 A1 und der US 10 263 134 B1 bekannt. Aus der US 2014 / 0 076 391 A1 ist eine Gruppe IV Teilzelle bekannt, wobei der Emitter eine größere Dicke als die Basis aufweist.

Monolithische Mehrfachsolarzellen hauptsächlich aus III-V Halbleitermaterial zeigen mit über 40% Wirkungsgrad auf dem Gebiet der Konzentratorsysteme bei terrestrischen Anwendungen besonders hohe Wirkungsgrade. Je höher der Wirkungsgrad und je geringer die Herstellungskosten desto konkurrenzfähiger sind die Konzentratorsysteme im Vergleich zu den herkömmlichen Silizlumsolarzellensystemen.

Vor dem Hintergrund besteht die Aufgabe der Erfindung darin, eine Vorrichtung anzugeben, die den Stand der Technik weiterbildet.

Die Aufgabe wird durch eine stapelförmige monolithische Mehrfachsolarzelle mit den Merkmalen des Patentanspruchs 1 gelöst. Vorteilhafte Ausgestaltungen der Erfindung sind Gegenstand von Unteransprüchen.

Die Erfindung betrifft eine stapelförmige monolithische Mehrfachsolarzelle aufweisend eine erste Teilzelle mit einem p/n Übergang mit einer Emitterschicht und einer Basisschicht.

Die Dicke der Emitterschicht ist wenigstens um einen Faktor fünf oder um einen Faktor zehn kleiner als die Dicke der Basisschicht.

Die erste Teilzelle umfasst ein Substrat mit einem Halbleitermaterial aus der Gruppe III und V oder ein Substrat aus der Gruppe IV.

Auf der ersten Teilzelle ist eine zweite Teilzelle angeordnet. Auf der zweiten Teilzelle ist eine dritte Teilzelle angeordnet.

Die zweite Teilzelle und die dritte Teilzelle weisen jeweils eine Emitterschicht und eine Basis auf.

Es versteht sich, dass die Emitterschicht n-dotiert und die Basisschicht p-dotiert sind.

Zwischen den Teilzellen sind jeweils eine Tunneldiode und eine Rückseitenfeldschicht ausgebildet, wobei bei der zweiten Teilzelle und / oder bei der dritten Teilzelle die Dicke der Emitterschicht jeweils größer ist als die Dicke der Basis bzw. der Basisschicht.

Es sei angemerkt, dass unter dem Begriff der Basis auch die dazugehörigen Basisschichten mitumfasst sind, auch wenn sich in einem Teil der Ausführungsbeispiele, die bisher ausschließlich als Rückseitenfeld Schichten, nunmehr als Basis mitverwendet werden.

Hierbei handelt es sich in allen Fällen um ganzflächige Schichten, die unmittelbar stoffschlüssig mit dem jeweiligen Emitter bzw. mit der jeweiligen Emitterschicht verbunden sind.

Es sei angemerkt, dass sich die vorliegende Anordnung auch auf Vierfach-Solarzellen oder Fünffach-Solarzellen übertragen lässt. Vorzugsweise ist die vierte Teilzelle unterhalb der zweiten Teilzelle oder oberhalb der dritten Teilzelle oder zwischen der zweiten und der dritten Teilzelle angeordnet.

In einer Weiterbildung ist die fünfte Teilzelle unterhalb der zweiten Teilzelle oder oberhalb der dritten Teilzelle oder zwischen der zweiten und der dritten Teilzelle angeordnet.

Des Weiteren sei angemerkt, dass als III-V Substratmaterial insbesondere GaAs oder InP bevorzugt ist. Als Gruppe IV-Substratmaterial ist insbesondere Germanium bevorzugt. Es versteht sich, dass die zweite Teilzelle und die dritte Teilzelle III-V Halbleitermaterialen umfassen oder aus III-V Halbleitermaterialen bestehen.

Vorzugsweise weisen alle auf der ersten Teilzelle angeordneten Teilzellen jeweils eine n auf p Struktur auf. Es sei angemerkt, dass die Basis der zweiten Teilzelle und / oder der dritten Teilzelle aus einer Basisschicht und / oder aus der Rückseitenfeldschicht gebildet ist.

Ein Vorteil der erfindungsgemäßen Mehrfachsolarzelle ist, dass im Gegensatz zu dem bisherigen Ansatz für Mehrfachsolarzellen mit drei oder mehr in Serie verschalteten Teilzellen, bei dem alle Emitterschichten wesentlich dünner als die Basis sind, sich in überraschender Weise die Effizienz der Mehrfachsolarzelle durch das erfindungsgemäße Design wesentlich steigern lässt.

Insbesondere ist es überraschend, da die Elektronen als Minoritätsladungsträger in der Basis eine höhere Beweglichkeit als die Löcher als Minoritätsladungsträger in der Emitterschicht aufweisen und das herkömmliche bisherige Design für Mehrfachsolarzellen mit einer im Vergleich zur Basis wesentlich dünneren Emitterschicht nahelegen.

Höchst überraschend lässt sich die vorliegende erfindungsmäße Mehrfachsolarzelle auch für metamorphe Mehrfachsolarzellen anwenden und hierdurch die Effizienz von metamorphen Mehrfachsolarzellen steigern.

Metamorphe Mehrfachsolarzell-Konzepte basieren auf der Implementierung eines metamorphen Puffers zwischen zwei aufeinanderfolgenden Teilzellen.

Ein Nachteil der metamorphen Konzepte ist es, dass die Defektdichte im Vergleich zu gitterangepassten Mehrfachsolarzellen wesentlich erhöht ist. Hierdurch reduziert sich die Minoritätsladungsträgerlebensdauer, wodurch insbesondere dünne Emitterschichten notwendig sind.

In der vorliegenden erfindungsgemäßen Mehrfachsolarzelle lässt sich in überraschender Weise zur Steigerung der Effizienz die Emitterschicht der zweiten und / oder dritten Teilzelle wesentlich dicker ausführen als die jeweilige Basis bzw. die Basisschicht.

Weiterhin hat sich überraschend gezeigt, dass eine Erhöhung der Effizienz auch bei hoher Konzentration der Sonneneinstrahlung auftritt. Durch die dickere Emitterschicht der obersten Teilsolarzelle wird die Querleitung zu den Metallfingern verbessert, sodass sich Serienwiderstandsverluste reduzieren und die Effizienz der Solarzelle verbessert. Ein Vorteil insbesondere für die Verwendung bei Konzentratorsolarzellen.

Des Weiteren ist es überraschend, dass sich die Absorption durch die vorliegende Ausführung einer Mehrfachsolarzelle erhöhen lässt. Hierdurch lässt sich in überraschender Weise die Gesamtdicke der Mehrfachsolarzelle verringern, ohne dass sich der Wirkungsgrad der Mehrfachsolarzelle reduziert. Ferner erhöht sich die Ausbeute und die Herstellungskosten reduzieren sich.

Weiterhin ist es überraschend, dass sich das Konzept von dickerer Emitterschicht als die zugehörige Basisschicht bei der Teilzelle T2 und / oder der Teilzelle T3 mit dem Konzept der dünneren Emitterschicht als die Basisschicht bei der Tellzelle T1 in einer Mehrfachsolarzelle vorteilhaft kombinieren lässt.

In einer Weiterbildung sind bei der zweiten Teilzelle und / oder bei der dritten Teilzelle jeweils die Rückseitenfeldschicht als Basis ausgebildet. Ein Vorteil ist, dass sich hierdurch die Gesamtdicke der Mehrfachsolarzelle und der Serienwiderstand der Mehrfachsolarzelle reduzieren lassen.

In einer Weiterbildung umfasst bei der zweiten Teilzelle und / oder bei der dritten Teilzelle die Rückseitenfeldschicht und die Emitterschicht unterschiedliche Halbleitermaterialen. In einer anderen Weiterbildung weist die Rückseitenfeldschicht eine andere Stöchiometrie als die Emitterschicht auf.

In einer Ausführungsform ist bei der zweiten Teilzelle und / oder bei der dritten Teilzelle die Dicke der Emitterschicht um einen Faktor drei oder um einen Faktor zehn oder um einen Faktor 15 oder um einen Faktor 20 größer als die Dicke der Basis.

In einer anderen Ausführungsform liegt die Dicke der Rückseitenfeldschicht in einem Bereich zwischen 20 nm und 100 nm oder in einem Bereich zwischen 40nm und 60nm, wobei die Dotierkonzentration in einem Bereich zwischen 5•10¹⁷ / cm³ und 5•10¹⁸ / cm³ oder in einem Bereich zwischen 9•10¹⁷ / cm³ und 2,5•10¹⁸ / cm³ liegt. Vorzugsweise ändert sich die Bandlückenenergie innerhalb der Rückseitenfeldschicht oder ist konstant. Bei einer Änderung der Bandlückenenergie ist es bevorzugt, dass die Änderung der Bandlückenenergie stufenförmig oder kontinuierlich im Verlauf mit der Dicke der Rückseitenfeldschicht vonstatten geht.

In einer Weiterbildung ist zwischen der ersten Teilzelle und der zweiten Teilzelle ein Halbleiterspiegel ausgebildet. Vorzugsweise ist der Halbleiterspiegel zwischen der ersten Teilzelle und der Rückseitenfeldschicht der zweiten Teilzelle ausgebildet.

In einer anderen Weiterbildung umfasst die Emitterschicht der zweiten Teilzelle ein (Al)InGaAs Material. Hierbei ist das Aluminium optional, d.h. der Gehalt an Aluminium ist in einer Weiterbildung gleich Null.

In einer Ausführungsform umfasst die Emitterschicht der dritten Teilzelle ein (Al)InGaP Material. Hierbei ist das Aluminium optional.

In einer Ausführungsform ist die erste Teilzelle als Ge-Teilzelle und die zweite Teilzelle als InGaAs Teilzelle und die dritte Teilzelle als InGaP Teilzelle ausgebildet.

In einer anderen Weiterbildung sind die Teilzellen der Mehrfachsolarzelle zueinander gitterangepasst ausgebildet. In einer Weiterbildung variiert die Gitterkonstanten zwischen den Teilzellen oder anders ausgedrückt die Gitterkonstante ist wenigstens zwischen zwei Teilzellen unterschiedlich.

In einer Ausführungsform ist zwischen der ersten Teilzelle und der zweiten Teilzelle ein metamorpher Puffer ausgebildet.

In einer Weiterbildung ist die Bandlückenenergie der zweiten Teilzelle größer als die Bandlückenenergie der ersten Teilzelle. Vorzugsweise ist die Bandlückenenergie der dritten Teilzelle größer als die Bandlückenenergie der zweiten Teilzelle.

In einer anderen Weiterbildung ist die Schichtdicke des Emitters der ersten Teilzelle in einem Bereich zwischen 50nm und 500nm oder in einem Bereich zwischen 80nm und 250nm, wobei die Dotierkonzentration in einem Bereich zwischen 5•10¹⁷ / cm³ und 5•10¹⁹ / cm³ oder in einem Bereich zwischen 9•10¹⁷ /cm³ und 5•10¹⁸ / cm³ liegt. Die Basis wird durch die Dicke des Substrats bestimmt und liegt oberhalb von 50 µm, wobei die Dotierung des Substrats in einem Bereich zwischen 4•10¹⁶ /cm³ und 1•10¹⁸ /cm³ oder in einem Bereich zwischen 1•10¹⁷ / cm³ und 6•10¹⁷ /cm³ liegt.

In einer anderen Weiterbildung ist die Schichtdicke des Emitters der zweiten Teilzelle in einem Bereich zwischen 1µm und 3,8 µm oder in einem Bereich zwischen 2,2 µm und 3,2 µm, wobei die Dotierkonzentration in einem Bereich zwischen 5•10¹⁶ / cm³ und 7•10¹⁷ / cm³ oder in einem Bereich zwischen 9•10¹⁶ / cm³ und 3•10¹⁷ / cm³ liegt.

Sofern zwischen der Rückseitenfeldschicht der zweiten Teilzelle und dem Emitter der zweiten Teilzelle eine Basisschicht ausgebildet ist, liegt die Dicke der Basisschicht in einem Bereich zwischen 10nm und 200nm oder in einem Bereich zwischen 40nm und 80nm und die Dotierung in einem Bereich zwischen 5•10¹⁷ / cm³ und 5•10¹⁸ / cm³ oder in einem Bereich zwischen 9•10¹⁷ / cm³ und 2,8•10¹⁸ / cm³.

In einer anderen Weiterbildung ist die Schichtdicke des Emitters der dritten Teilzelle in einem Bereich zwischen 200nm und 1500nm oder in einem Bereich zwischen 0,7 µm und 1,2 µm, wobei die Dotierkonzentration in einem Bereich zwischen 5•10¹⁶ /cm³ und 5•10¹⁷ / cm³ oder in einem Bereich zwischen 9•10¹⁶ / cm³ und 3•10¹⁷ / cm³ liegt.

Sofern zwischen der Rückseitenfeldschicht der dritten Teilzelle und dem Emitter der dritten Teilzelle eine Basisschicht ausgebildet ist, liegt die Dicke der Basisschicht in einem Bereich zwischen 10nm und 120nm oder in einem Bereich zwischen 40nm und 80nm und die Dotierung in einem Bereich zwischen 5•10¹⁷ / cm³ und 5•10¹⁸ / cm³ oder in einem Bereich zwischen 9•10¹⁷ / cm³ und 2,8•10¹⁸ / cm³.

In einer Weiterbildung weist bei der zweiten Teilzelle und / oder bei der dritten Teilzelle der Emitter eine geringere Dotierung als die Basis auf. Im Unterschied dazu weist bei der ersten Teilzelle und der fünften Teilzelle und bei der vierten Teilzelle der Emitter eine höhere Dotierung als die Basis auf.

In einer Weiterbildung ist der Emitter aller Teilzellen der Mehrfachsolarzelle n-dotiert und die Basis aller Teilzellen p-dotiert.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände sowie die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Querschnitt von einer Ausführungsform einer Mehrfachsolarzelle mit drei Teilzellen,
- Figur 2: einen Querschnitt von einer weiteren Ausführungsform einer Mehrfachsolarzelle mit drei Teilzellen.
- Figur 3: einen Querschnitt von einer weiteren Ausführungsform einer Mehrfachsolarzelle mit fünf Teilzellen.

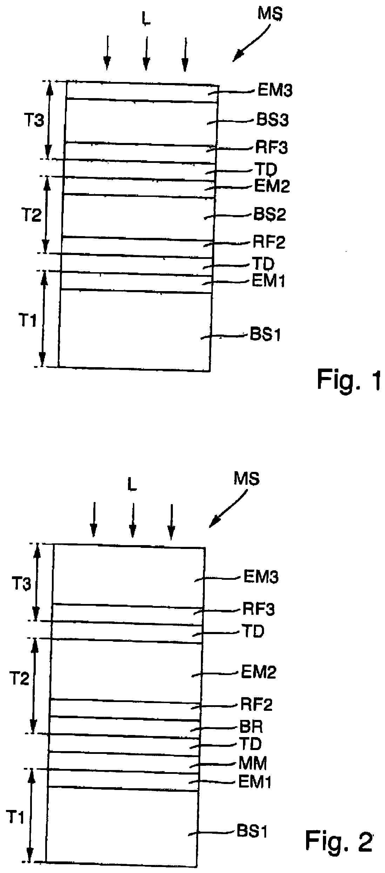

Die Abbildung der Figur 1 zeigt eine Querschnittsansicht auf eine Ausführungsform einer stapelförmige monolithische Dreifachsolarzelle MS, mit einer ersten Teilzelle T1 und einer zweiten Teilzelle T2 und einer dritten Teilzelle T3. Bei einer Bestrahlung mit Licht L trifft das immer zuerst auf den Emitter der obersten Teilzelle.

Zwischen den einzelnen Teilzellen T1, T2 und T3 ist jeweils eine Tunneldiode TD ausgebildet.

Es versteht sich, dass aus Gründen der Übersichtlichkeit insbesondere Metall- bzw. Anschlusskontaktschichten als auch Fensterschichten und Antireflektionsschichten nicht dargestellt sind. Auch sei angemerkt, dass der Emitter n-dotiert und die Basis p-dotiert ist.

Vorliegend sind die drei Teilzellen T1, T2 und T3 zueinander gitterangepasst ausgeführt.

Es sei angemerkt, dass in einer nicht dargestellten Ausführungsform oberhalb der ersten Teilzelle T1 auch eine vierte Teilzelle und / oder eine fünfte Teilzelle optional ausgebildet sind.

Die erste Teilzelle T1 weist eine n-dotierte Emitterschicht EM1 und eine p-dotierten Basisschicht BS1 auf, wobei die Dicke der Emitterschicht EM1 wenigstens um einen Faktor zehn kleiner ist als die Dicke der Basisschicht BS1 ist.
Die ersten Teilzelle T1 lässt sich auch als Substratzelle bezeichnen und umfasst vorliegend Ge als Halbleitermaterial. Es versteht sich, dass anstelle von Ge sich auch insbesondere GaAs oder InP als Substratmaterial verwenden lässt.

Auf der ersten Teilzelle T1 ist eine zweite Teilzelle T2 angeordnet. Die zweite Teilzelle T2 weist eine größere Bandlücke als die erste Teilzelle T1 auf. Auf der zweiten Teilzelle T2 ist eine dritte Teilzelle T3 angeordnet. Die dritte Teilzelle T3 weist eine größere Bandlücke als die zweite Teilzelle T2 auf.

Zwischen der ersten Teilzelle T1 und der zweiten Teilzelle T2 und zwischen der zweiten Teilzelle T2 und der dritten Teilzelle T3 ist jeweils eine Tunneldiode TD angeordnet.

Die zweite Teilzelle T2 weist eine oberhalb der Tunneldiode TD angeordnete Rückseitenfeldschicht RF2 und eine oberhalb der Rückseitenfeldschicht RF2 angeordnete optionale Basisschicht BS2 und eine oberhalb der Basisschicht angeordnete Emitterschicht EM2 auf, wobei die Emitterschicht EM2 wenigstens um den Faktor 10 dicker als die optionale Basisschicht BS2 und / oder die Rückseitenfeldschicht RF2 ist.

Die dritte Teilzelle T3 weist eine oberhalb der Tunneldiode TD angeordnete Rückseitenfeldschicht RF3 und eine oberhalb der Rückseitenfeldschicht RF3 angeordnete optionale Basisschicht BS3 und eine oberhalb der Basisschicht angeordnete Emitterschicht EM3 auf, wobei die Emitterschicht EM3 wenigstens um den Faktor 10 dicker als die optionale Basisschicht BS3 und / oder die Rückseitenfeldschicht RF3 ist.

Die Abbildung der Figur 2 zeigt eine Querschnittsansicht auf eine weitere Ausführungsform einer stapelförmige monolithische Dreifachsolarzelle MS. Im Folgenden werden nur die Unterschiede zu der Ausführungsform dargestellt in der Figur 1 erläutert.

Zwischen der ersten Teilzelle T1 und der zweiten Teilzelle T2 sind ein metamorpher Puffer MM und ein Halbleiterspiegel BR angeordnet.

In einer nicht dargestellten Ausführungsform sind entweder nur der metamorphe Puffer MM oder nur der Halbleiterspiegel BR ausgebildet.

Bei der zweiten Teilzelle T2 und der dritten Teilzelle T3 sind jeweils die Basisschichten BS2 und BS3 nicht ausgebildet. Hierdurch bilden die Rückseitenfeldschicht RF2 und RF3 jeweils die Basis der beiden Teilzellen T2 und T3. Vorzugsweise weisen die Rückseitenfeldschichten RF2 und RF3 jeweils eine andere Stöchiometrie oder eine anderes Halbleitermaterial als die jeweils unmittelbar auf den Rückseitenfeldschichten RF2 bzw. RF3 ausgebildeten Emitterschichten EM2 und EM3 auf.

Derartige Teilzellen werden auch als Heterozellen bezeichnet.

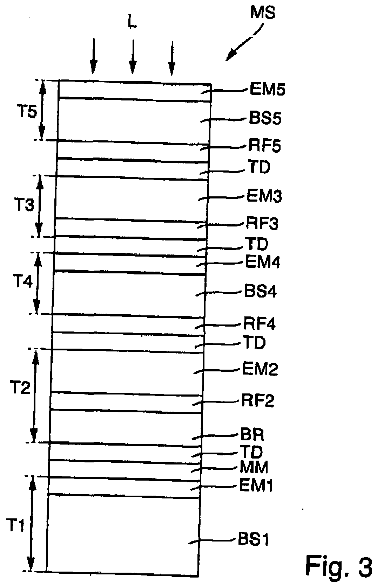

Die Abbildung der Figur 3 zeigt eine Querschnittsansicht auf eine weitere Ausführungsform einer stapelförmige monolithische Fünffachsolarzelle MS. Im Folgenden werden nur die Unterschiede zu der Ausführungsform, dargestellt in der Figur 2, erläutert.

Zwischen der zweiten Teilzelle T2 und der dritten Teilzelle T3 ist ein vierte Teilzelle T4 mit einem Emitter mit einer Emitterschicht EM4 und einer Basis mit einer Basisschicht BS4 angeordnet. Zwischen der Basisschicht BS4 und der zweiten Teilzelle T2 ist eine Rückseitenfeldschicht RF4 ausgebildet. Zwischen der Rückseitenfeldschicht RF4 und der zweiten Teilzelle T2 ist eine Tunneldiode TD ausgebildet. Die Dicke der Basisschicht BS4 ist entsprechend dem bisherigen Stand der Technik größer als die Dicke der Emitterschicht EM4.

Auf der dritten Teilzelle T3 ist eine fünfte Teilzelle T5 mit einem Emitter mit einer Emitterschicht EM5 und einer Basis mit einer Basisschicht BS5 angeordnet. Zwischen der Basisschicht BS5 und der dritten Teilzelle T3ist eine Rückseitenfeldschicht RF5 ausgebildet. Zwischen der Rückseitenfeldschicht RF5 und der dritten Teilzelle T3 ist eine Tunneldiode TD ausgebildet. Die Dicke der Basisschicht BS5 ist, entsprechend dem bisherigen Stand der Technik, größer als die Dicke der Emitterschicht EM5.

## Patentansprüche

1. Stapelförmige monolithische Mehrfachsolarzelle (MS), aufweisend
- eine erste Teilzelle (T1) mit einem p/n Übergang mit einer Emitterschicht (EM1) und einer Basisschicht (BS1), wobei die Dicke der Emitterschicht (EM1) wenigstens um einen Faktor fünf kleiner ist als die Dicke der Basisschicht (BS1) und die erste Teilzelle (T1) ein Substrat mit einem Halbleitermaterial aus der Gruppe III und V oder ein Substrat aus der Gruppe IV umfasst,
- eine auf der ersten Teilzelle (T1) angeordnete zweite Teilzelle (T2),
- eine auf der zweiten Teilzelle (T2) angeordnete dritte Teilzelle (T3),
wobei die beiden Teilzellen (T2, T3) jeweils eine Emitterschicht (EM2, EM3) und eine Basis aufweisen, wobei
zwischen den Teilzellen (T1, T2, T3) jeweils eine Tunneldiode (TD) und eine Rückseitenfeldschicht (RF2, RF3) ausgebildet ist,
**dadurch gekennzeichnet, dass**
die zweite Teilzelle und die dritte Teilzelle III-V Halbleitermaterialen umfassen, und
bei der zweiten Teilzelle (T2) und / oder bei der dritten Teilzelle (T3) jeweils die Dicke der Emitterschicht (EM2, EM3) größer ist als die Dicke der Basis.

2. Stapelförmige monolithische Mehrfachsolarzelle (MS) nach Anspruch 1, **dadurch gekennzeichnet, dass** bei der zweiten Teilzelle (T2) und / oder bei der dritten Teilzelle (T3) die Rückseitenfeldschicht (RF2, RF3) als Basis ausgebildet ist.

3. Stapelförmige monolithische Mehrfachsolarzelle (MS) nach Anspruch 1 oder Anspruch 2, **dadurch gekennzeichnet, dass** bei der zweiten Teilzelle (T2) und / oder bei der dritten Teilzelle (T3) jeweils die Rückseitenfeldschicht (RF2, RF3) im Verhältnis zu der Emitterschicht (EM2, EM3) ein unterschiedliches Halbleitermaterial umfasst oder die Rückseitenfeldschicht (RF2, RF3) eine andere Stöchiometrie als die Emitterschicht (EM2, EM3) aufweist und jeweils die Rückseitenfeldschicht (RF2, RF3) eine höhere Bandlücke als die Emitterschicht (EM2, EM3) aufweist.

4. Stapelförmige monolithische Mehrfachsolarzelle (MS) nach einem der Ansprüche 1 bis 3, **dadurch gekennzeichnet, dass** bei der zweiten Teilzelle (T2) und / oder bei der dritten Teilzelle (T3) jeweils die Dicke der Emitterschicht (EM2, EM3) um einen Faktor fünf oder um einen Faktor zehn größer ist als die Dicke der Basis und / oder der Rückseitenfeldschicht (RF2, RF3).

5. Stapelförmige monolithische Mehrfachsolarzelle (MS) nach einem der Ansprüche 1 bis 4, **dadurch gekennzeichnet, dass** die Dicke der Rückseitenfeldschicht (RF2, RF3) in einem Bereich zwischen 20 nm und 100 nm liegt und die Bandlückenenergie sich innerhalb der Rückseitenfeldschicht (RF2, RF3) ändert oder konstant ist.

6. Stapelförmige monolithische Mehrfachsolarzelle (MS) nach einem der Ansprüche 1 bis 5, **dadurch gekennzeichnet, dass** zwischen der ersten Teilzelle (T1) und der zweiten Teilzelle (T2) ein Halblelterspiegel (BR) ausgebildet ist.

7. Stapelförmige monolithische Mehrfachsolarzelle (MS) nach einem der Ansprüche 1 bis 6, **dadurch gekennzeichnet, dass** die Emitterschicht (EM2) der zweiten Teilzelle (T2) ein (Al)InGaAs Material umfasst.

8. Stapelförmige monolithische Mehrfachsolarzelle (MS) nach einem der Ansprüche 1 bis 7, **dadurch gekennzeichnet, dass** die Emitterschicht (EM3) der dritten Teilzelle (T3) ein (Al)InGaP Material umfasst.

9. Stapelförmige monolithische Mehrfachsolarzelle (MS) nach einem der Ansprüche 1 bis 8, **dadurch gekennzeichnet, dass** die Teilzellen (T1, T2, T3) zueinander gitterangepasst ausgebildet sind oder die Gitterkonstanten zwischen wenigstens zwei Teilzellen (T1, T2, T3) unterschiedlich sind.

10. Stapelförmige monolithische Mehrfachsolarzelle (MS) nach einem der Ansprüche 1 bis 9, **dadurch gekennzeichnet, dass** zwischen der ersten Teilzelle (T1) und der zweiten Teilzelle (T2) ein metamorpher Puffer (MM) ausgebildet ist.

11. Stapelförmige monolithische Mehrfachsolarzelle (MS) nach einem der Ansprüche 1 bis 10, **dadurch gekennzeichnet, dass** die Bandlückenenergie der zweiten Teilzelle (T2) größer ist als die Bandlückenenergie der ersten Teilzelle (T1) und die Bandlückenenergie der dritten Teilzelle (T3) größer ist als die Bandlückenenergie der zweiten Teilzelle (T2).

12. Stapelförmige monolithische Mehrfachsolarzelle (MS) nach einem der Ansprüche 1 bis 11, **dadurch gekennzeichnet, dass** unterhalb der zweiten Teilzelle (T2) oder oberhalb der dritten Teilzelle (T3) oder zwischen der zweiten Teilzelle (T2) und der dritten Teilzelle (T3) eine vierte Teilzelle (T4) angeordnet ist.

13. Stapelförmige monolithische Mehrfachsolarzelle (MS) nach Anspruch 12, **dadurch gekennzeichnet, dass** unterhalb der zweiten Teilzelle (T2) oder oberhalb der dritten Teilzelle (T3) oder zwischen der vierten Teilzelle (T4) und der dritten Teilzelle (T3) eine fünfte Teilzelle (T5) angeordnet ist.

14. Stapelförmige monolithische Mehrfachsolarzelle (MS) nach einem der Ansprüche 1 bis 13, **dadurch gekennzeichnet, dass** bei der zweiten Teilzelle (T2) und / oder bei der dritten Teilzelle (T3) der Emitter eine geringere Dotierung als die Basis aufweist.
